# EUROPEAN PATENT APPLICATION

(11) **EP 3 843 512 A1**
(43) Date of publication of application: **30.06.2021**
(21) Application number: 19219295.3
(22) Date of filing: 23.12.2019
(51) Int. Cl.: H05K 7/20, H01L 23/473

(54) **COOLING SYSTEM FOR COOLING AN ELECTRONIC COMPONENT, METHOD FOR ASSEMBLING A COOLING SYSTEM, ELECTRONIC CONTROL UNIT AND VEHICLE**

(71) Applicant: Aptiv Technologies Limited, St. Michael (BB)
(72) Inventor: Klink, Volker, 53773 Hennef (DE); Rieke, Matthias, 41352 Korschenbroich (DE); Rademacher, Falk, 51647 Gummersbach (DE)
(74) Representative: Manitz Finsterwald Patent- und Rechtsanwaltspartnerschaft mbB

(57) **Abstract**

The present disclosure relates to a cooling system for cooling an electronic component, the cooling system comprising a heat sink with a cooling channel for guiding a liquid. The heat sink comprises an external surface comprising at least one opening which partially exposes the cooling channel. The electronic component is mounted to the external surface such that the electronic component covers the opening. A sealing material is arranged between the electronic component and the external surface for at least partially sealing the electronic component against the liquid. The present disclosure further relates to a method for assembling a cooling system, the method comprising: forming at least one opening through an external surface of a heat sink; dispensing a sealing material in a liquid state over the external surface around the at least one opening for forming a molding; and pressing the electronic component onto the molding.

## Description

### FIELD

The present disclosure relates to a cooling system and a method for assembling the cooling system for cooling an electronic component, the cooling system comprising the electronic component and a heat sink. The present disclosure further relates to an electronic control unit and a vehicle.

### BACKGROUND

Current electronic control units have several processors with high power dissipation. It is known to use liquid cooling as means to get rid of heat which results out of the high power dissipation.

Challenges of known concepts are that each element separating the cooling structure from the electronic components of the electronic control unit introduces a big thermal resistance to the overall system, which results in a loss of efficiency of the cooling. A thermal interface material separating the electronic part from the cooling structure has to be relatively thick to compensate all tolerances of the electronic parts as well as of the cooling structure, wherein the tolerances occur due to manufacturing processes like soldering or milling, for instance. These tolerances cannot be avoided completely and cause a lack of efficiency of the cooling system..

Accordingly, there is a need to provide a cooling system for cooling an electronic component, which is particularly highly efficient, as well as a method for assembling such a cooling system. Furthermore, there is a need to provide an electronic control unit and a vehicle comprising the electronic control unit that is particularly well protected against overheating of its electronic parts.

### SUMMARY

The present disclosure provides a cooling system, an electronic control unit, a vehicle and a method for assembling a cooling system according to the independent claims. Embodiments are given in the subclaims, the description and the drawings.

In one aspect, the present disclosure is directed at a cooling system for cooling at least one electronic component. For example, the at least one electric component can be an electronic component of an electronic control unit, such as a processor or a semiconductor chip or an integrated circuit or a printed circuit board. The cooling system comprises the at least one electric component and a heat sink, wherein the heat sink comprises at least one cooling channel for guiding a liquid, e.g. a liquid coolant through the heat sink. For example, the at least one cooling channel can be designed to guide an electrically conducting liquid and/or a liquid comprising water and/or a glycol solution, or a glycol based coolant. Other possible liquids are liquid metals, salt solutions or liquified gases such as hydrogen or helium. The heat sink comprises an external surface at which the electronic component is mounted to the heat sink. Preferably, the external surface is flat. In particular, a housing of the electronic component is mounted to the flat external surface of the heat sink. Furthermore, a housing of the heat sink can at least partially form the external surface. For example, the heat sink is designed as a cold plate comprising a metal housing. Alternatively, a housing of the heat sink can be composed of a glass material and/or a plastic material and/or a synthetic material and/or a waterproof material. The housing of the heat sink can be in direct contact with the housing of the electronic component. A structure of the electronic component itself does not need any alteration.

The external surface of the heat sink comprises at least one opening at least partially exposing the at least one cooling channel. In other words, the cooling channel can at least partially be in direct contact with the electronic component via the at least one opening. A respective electronic component of the at least one electronic component is mounted to the external surface such that the electronic component covers the at least one opening. The cooling system further comprises a sealing material, which is arranged between the external surface of the heat sink and the electronic component such that the electronic component is sealed against the liquid coolant. For example, the liquid flowing through the at least one cooling channel can be released at the at least one opening and directly flow over the electronic component. The sealing material can be arranged such that the flow of the liquid is restricted. For example, the sealing material is arranged such that the liquid does not flow beyond the limits of the surface of the electronic component that is in contact with the heat sink. This allows sealing other electronic components, such as a neighbouring electronic component or a printed circuit board against the liquid.

In this way, an efficient cooling of the electronic component can be achieved, since no intermediate element or no thermal interface material is positioned between the electronic component and the cooling channel. Therefore, no additional thermal resistance is introduced into the cooling system. The liquid flowing through the cooling channel can directly flow over a surface of the electronic component. Therefore, an overall thermal conductivity of parts of the cooling system, as for example a housing of the heat sink, becomes less important, allowing the use of different materials other than high thermally conductive materials, such as a metal, for these parts of the cooling system. Furthermore, an efficient cooling of the electronic component can be achieved without any alteration of the electronic component from a standard structure.

According to an embodiment, the sealing material is arranged between the electronic component and the external surface of the heat sink such that the electronic component is at least partially in direct contact with the liquid when the liquid is flowing through the at least one cooling channel. The sealing material is therefore arranged around the at least one opening without covering the opening itself. The liquid can therefore freely flow over the electronic component and provide an efficient cooling.

According to an embodiment, the sealing material comprises a glueing agent. The glueing agent can be a bonding agent or an adhesive. In particular, the sealing material can be a double-sided adhesive tape. The sealing material can comprise or form several layers, as for example several layers of glue. Preferably, the sealing material corresponds to a thermoplastic material. Particularly preferably, the sealing material is a hot melt adhesive. In other words, the sealing material is a dispensable material, which has been dispensed onto the flat surface of the heat sink in a liquid state. Therefore, the electronic component itself and/or neighbouring electronic components are particularly well sealed against the liquid, e.g. a coolant, and thus protected against any damage.

According to an embodiment, the sealing material is coolant resistant and/or rigid. The sealing material can be resistant to a pressure that arises within the heat sink due to a flow of the coolant. In other words, the sealing material withstands the pressure demands of the cooling system. For example, the sealing material is resistant to a pressure of at least 1 bar, preferably of at least 2 bar. The cooling system is therefore designed to keep the electronic component sealed against the liquid even when a pressure is introduced against the sealing, for example due to the flow of the liquid through the cooling channel and on the surface of the electronic component.

According to an embodiment, the electronic component is mounted to the heat sink in a form-fit-free manner and in a friction-free manner. The electronic component can be attached to the heat sink solely via the sealing material. For example, if the sealing material is a hot melt adhesive, the electronic component is glued the heat sink. In particular, no soldering process is needed for attaching the electronic component to the heat sink. The form-fit-free and friction-free connection allows designing a particularly lightweight cooling structure which can be assembled in a particularly easy and fast manner.

According to an embodiment, the electronic component is mounted to the heat sink via gluing or via soldering. The at least one electronic component can be soldered to the printed circuit board on one side and to the heat sink on the other side.

According to an embodiment, the sealing material forms a shape which corresponds to a perimeter of a two-dimensional geometrically symmetric shape. For example, the sealing material can form a continuous line on the external surface of the heat sink. In particular, the sealing material forms a shape which corresponds to a perimeter of a rectangle. Alternatively, the sealing material is ring-shaped. Due to the sealing material having a geometric shape, the liquid can be bounded within a definite space. The at least one opening can be designed to extend over an area that is delimited by the sealing material, therefore allowing the electronic component to be in thermal contact with as much liquid as possible without risking leaks in the cooling system.

According to an embodiment, the sealing material extends along a perimeter of the electronic component. The at least one opening can extend within a surface enclosed by the sealing material, such that the surface of the electronic component which is mounted to the external surface of the heat sink can be in direct contact with the liquid. Thus, a particularly large surface of the liquid is in direct contact with the electronic component, allowing the particularly efficient cooling of the electronic component.

According to an embodiment, the heat sink comprises a pedestal which forms the external surface. In other words, a body of the heat sink is not entirely flat, but forms an elevation providing the external surface which at least partially exposes the at least one cooling channel. In particular, the external surface of the pedestal can be flat. A size of the pedestal can correspond to a size of the surface of the electronic component that is to be mounted on the pedestal. For example, a length and a width of the external surface provided by the pedestal correspond to a length and a width of the surface of the electronic component that is to be mounted onto the pedestal. In particular, the sealing material can extend along the perimeter of the external surface of the pedestal and the opening can be formed within the surface delimited by the sealing material on the external surface of the pedestal. The elevation due to the pedestal allows mounting different electronic components in the vicinity of the electronic component mounted to the heat sink. For example, a plurality of electronic components is mounted on a printed circuit board, the electronic components having different sizes. The pedestal allow to accommodate all electronic components in the space within the heat sink and the printed circuit board, according to their different sizes.

According to an embodiment, the cooling system is configured for cooling a plurality of electronic components. The heat sink comprises a plurality of pedestals, wherein each pedestal forms an external surface for mounting a respective electronic component of the plurality of the electronic components. The external surfaces formed by the plurality of the pedestals can each comprise different dimensions, such that a dimension of a respective external surface corresponds to a dimension of the surface of the respective electronic component that is to be mounted to the pedestal. With this, an efficient cooling of several electronic components can be realized with a single heat sink.

In another aspect, the present disclosure is directed at an electronic control unit, said electronic control unit comprising the cooling system described herein. For example, the electronic control unit is designed for use in the operation of a vehicle.

It is understood that features described in connection with the cooling system can be realized in the electronic control unit and vice versa.

In another aspect, the present disclosure is directed at a vehicle, said vehicle comprising the electronic control unit described herein. The vehicle comprises a cooling circuit. The electronic control unit is connected to the cooling circuit of the vehicle, such that a coolant of the cooling circuit is guided to the at least one cooling channel of the heat sink of the cooling system of the electronic control unit. In other words, the coolant used for cooling components of the vehicle, such as for example an engine component, is also used for cooling the electronic component of the electronic control unit.

It is understood that features described in connection with the cooling system as well as in connection with the electronic control unit can be realized in the vehicle and vice versa.

In another aspect, the present disclosure is directed at a method for assembling a cooling system for cooling an electronic component. The method comprises the following steps. First, at least one opening is formed through an external surface of the heat sink, wherein the at least one opening exposes at least partially a cooling channel of the heat sink. The at least one opening can be formed for example by drilling or milling or by cutting through the external surface. A position of the at least one opening can be chosen on the external surface on a location of the at least one cooling channel within the heat sink.

In a second step, the sealing material is dispensed in a liquid state over the external surface around the at least one opening. The sealing material forms a mold respectively a molding. In a third step, the electronic component respectively a housing of the electronic component is pressed onto the molding formed by the sealing material. Finally, the sealing material can harden into a solid state, attaching the electronic component to the flat external surface of the heat sink.

It is understood that features described in connection with the cooling system as well as in connection with the electronic control unit and the vehicle can be realized for the method and vice versa.

### DRAWINGS

Exemplary embodiments and functions of the present disclosure are described herein in conjunction with the following drawings, showing schematically:
- Fig. 1: an schematic exploded-view of a cooling system comprising a heat sink, an integrated circuit and a printed circuit board;
- Fig. 2: a schematic cross-sectional view of the assembled cooling system shown in Fig. 1;
- Fig. 3: a schematic cross-sectional view of a cooling system with a plurality of electronic components;
- Fig. 4: a schematic cross-sectional view of a further embodiment of the cooling system with a plurality of electronic components; and
- Fig. 5: a schematic diagram of a method for assembling a cooling system for cooling an electronic component.

### DETAILED DESCRIPTION

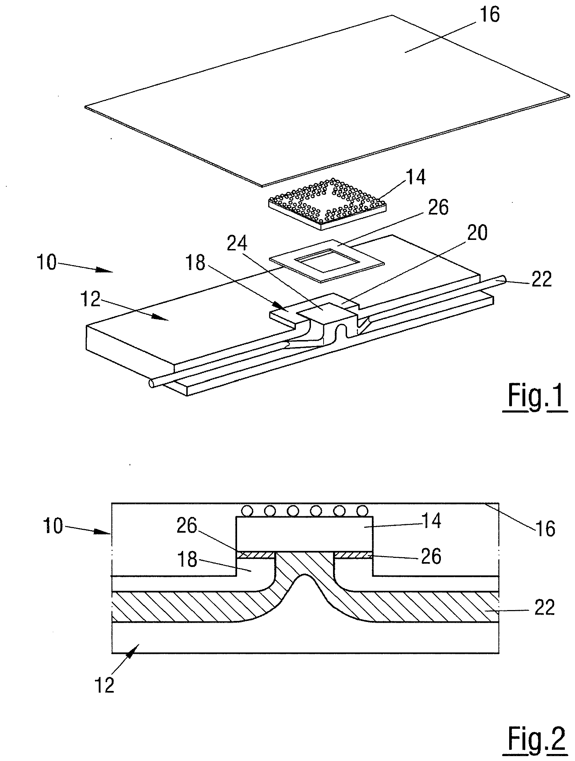

Fig. 1 depicts an exploded-view of a cooling system 10 comprising a heat sink 12 and an integrated circuit 14. The integrated circuit 14 shown here is designed as a ball grid array. The integrated circuit 14 can alternatively be designed as a dual in-line package or any other common integrated circuit package. Fig. 1 further depicts a printed circuit board 16 on which the integrated circuit 14 is to be attached. Fig. 2 shows a cross-sectional view of the same cooling system 10, wherein the cooling system 10 shown in fig. 2 is assembled. The heat sink 12 is shown in fig. 1 with a cross-sectional cut in order to reveal an inner part of the heat sink 12. The heat sink 12 can be designed as a plate with a metal housing, such as an aluminum housing. Alternatively, the housing of the heat sink 12 can comprise and/or be entirely formed of a plastic material respectively a synthetic material. The heat sink 12 forms a pedestal 18 on its outer surface, wherein the pedestal 18 provides a flat external surface 20. In other words, the flat external surface 20 of the pedestal 18 is elevated compared to a remaining outer surface of the heat sink 12. The heat sink 12 houses a cooling channel 22 which extends for example along a length of the heat sink 12, as shown in figs 1 and 2. The cooling channel 22 further passes through the pedestal 18 and in particular passes along the flat external surface 20 of the pedestal 18.

In order to cool the integrated circuit 14, an opening 24 is formed through the flat external surface 20 of the pedestal 18. The opening 24 is partially shown in fig. 1, wherein the opening 24 shown has a cross-section of a square. Via the opening 24, the cooling channel 22 is partially exposed to an exterior of the heat sink 12. A sealing material 26 is dispensed over the flat external surface 20. Preferably, as shown in fig. 1, the sealing material 26 is dispensed along a perimeter of the flat external surface 20 respectively of a surface of the integrated circuit 14 that is to be attached to the pedestal 18. The sealing material 26 is dispensed along a border of the opening 24, such that liquid or liquid coolant flowing from the cooling channel 22 over an electronic part of the integrated circuit 14 other than its housing or over the printed circuit board 16 can be avoided. As shown in fig. 1, the shape of the sealing material 26 corresponds to a hollow square, the dimensions of the square corresponding to the dimensions of the surface of the integrated circuit 14.

As shown in fig. 2 in a mounted state, the integrated circuit 14 respectively its housing is in direct contact with the cooling channel 22, such that a liquid is in direct contact with the integrated circuit 14 when the liquid flows through the cooling channel 22. The connection respectively an attachment of the integrated circuit 14 to the pedestal 18 of the heat sink 12 is realized only via the sealing material 26. The connection is therefore form-fit-free and friction-free. The sealing material 26 is water resistant and/or resistant to components comprised by the coolant such as glycol or the like.

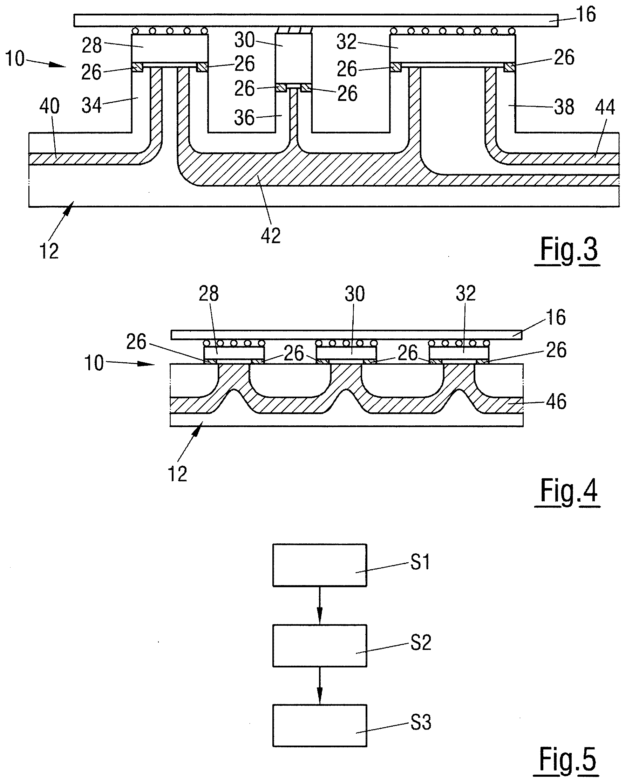

Fig. 3 shows a cross-sectional view of the cooling system 10 in a further embodiment. The cooling system 10 is configured to cool a plurality of electronic components, as shown here three differently sized electronic components 28, 30, 32. For this, the heat sink 12 comprises three pedestals 34, 36, 38, each configured to be mounted to one of the electronic components 28, 30, 32. For this, the three pedestals 34, 36, 38 are differently sized, wherein each dimension of a respective pedestal 34, 36, 38 is adapted to a dimension of the respective electronic component 28, 30, 32. The electronic components 28, 30, 32 can be connected to the printed circuit board 16. Each pedestal 34, 36, 38 forms a flat external surface 20 whose dimensions correspond to the dimensions of the respective surface of the electronic component 28, 30, 32 that is to be mounted onto the respective pedestal 34, 36, 38. The heat sink 12 comprises a plurality of cooling channels, as shown here in fig. 3 three cooling channels 40, 42, 44. The cooling channels 40, 42, 44 are guided to the external surfaces 20 of one or more pedestals 34, 36, 38. Alternatively, the heat sink 12 could comprise only one cooling channel that is guided through each of the pedestals 34, 36, 38. The heat sink 12 shown in fig. 3 comprises a total of three openings 24, wherein each electronic component 28, 30, 32 is sealed at its outer surface against the liquid with the sealing material 26.

Fig. 4 shows a cross-sectional view of the cooling system 10 in a further embodiment, wherein the cooling system 10 is configured to cool a plurality of electronic components as the embodiment shown in fig. 3. Compared to fig. 3, the cooling system 10 does not comprise any pedestals. Instead, the external surface of the heat sink 12 is flat and comprises the here shown three openings at which the electronic components 28, 30, 32 are attached. The here shown electronic components 28, 30, 32 have identical sizes, such that a spacing between the printed circuit board 16 and the heat sink 12 is the same over a length respectively a width of the heat sink 12. Thus, no pedestals are required as compared to the embodiment shown in fig. 3. The heat sink 12 comprises a single cooling channel 46 connected to all electronic components 28, 30, 32 via the respective openings.

Fig. 5 shows schematically a diagram of the steps of a method for assembling a cooling system 10. In a first step S1, an opening 24 is formed through the external surface 20 of the heat sink 12, wherein the opening 24 is formed such that the opening exposes at least partially the cooling channel 22 of the heat sink 12. The opening 24 can be drilled, milled or cut through the flat external surface 20. In a second step S2, the sealing material 26 is dispensed in a liquid state around the opening 24, such that the sealing material 26 forms a molding. In a third step S3, the integrated circuit 14 respectively the electronic component 28, 30, 32 is pressed onto the molding formed by the sealing material 26.

### Reference numeral list

- 10: cooling system
- 12: heat sink
- 14: integrated circuit
- 16: printed circuit board
- 18: pedestal
- 20: flat external surface
- 22: cooling channel
- 24: opening
- 26: sealing material
- 28: electronic component
- 30: electronic component
- 32: electronic component
- 34: pedestal
- 36: pedestal
- 38: pedestal
- 40: cooling channel
- 42: cooling channel
- 44: cooling channel
- 46: cooling channel

## Claims

1. A cooling system (10) for cooling at least one electronic component (14, 16, 28, 30, 32), the cooling system (10) comprising the at least one electronic component (14, 16, 28, 30, 32) and a heat sink (12) with at least one cooling channel (22, 40, 42, 44, 46) for guiding a liquid through the heat sink (12), wherein the heat sink (12) comprises an external surface (20) with at least one opening (24) which at least partially exposes the at least one cooling channel (22, 40, 42, 44, 46), wherein a respective electronic component (14, 16, 28, 30, 32) is mounted to the external surface (20) such that the electronic component (14, 16, 28, 30, 32) covers the at least one opening (24), and wherein the cooling system (10) comprises a sealing material (26) arranged between the electronic component (14, 16, 28, 30, 32) and the external surface (20) for at least partially sealing the electronic component (14, 16, 28, 30, 32) against the liquid.

2. The cooling system (10) according to claim 1, wherein the sealing material (26) is arranged between the electronic component (14, 16, 28, 30, 32) and the external surface (20) of the heat sink (12) such that the electronic component (14, 16, 28, 30, 32) is at least partially in direct contact with the liquid when the liquid is flowing through the at least one cooling channel (22, 40, 42, 44, 46).

3. The cooling system (10) according to any one of the precedent claims, wherein the sealing material (26) comprises a gluing agent, e.g. a thermoplastic material or a hot melt adhesive.

4. The cooling system (10) according to any one of the precedent claims, wherein the sealing material (26) is coolant resistant and/or wherein the sealing material (26) is rigid, e.g. wherein the sealing material (26) is resistant to a pressure of at least 1 bar and/or at least 2 bar.

5. The cooling system (10) according to any one of the precedent claims, wherein the mounting between the electronic component (14, 16, 28, 30, 32) and the external surface (20) of the heat sink (12) is form-fit-free and friction-free.

6. The cooling system (10) according to any one of the precedent claims, wherein the electronic component (14, 16, 28, 30, 32) is mounted to the external surface (20) of the heat sink (12) via gluing or via soldering.

7. The cooling system (10) according to any one of the precedent claims, wherein the sealing material (26) comprises a shape which corresponds to a perimeter of a two-dimensional geometrically symmetric shape, e.g. wherein the at least one opening (24) comprises a shape which corresponds to a perimeter of a rectangle or wherein the at least one opening (24) is ring-shaped.

8. The cooling system (10) according to any one of the precedent claims, wherein the sealing material (26) extends along a perimeter of the electronic component (14, 16, 28, 30, 32).

9. The cooling system (10) according to claims 7 or 8, wherein the at least one opening (24) extends over an entire area enclosed by the sealing material (26).

10. The cooling system (10) according to any one of the precedent claims, wherein the electronic component (14, 16, 28, 30, 32) is one of the following: a processor, a semiconductor chip, an integrated circuit or a printed circuit board.

11. The cooling system (10) according to any one of the precedent claims, wherein the heat sink (12) comprises a pedestal (18) which forms the external surface (20).

12. The cooling system (10) according to any one of the precedent claims, wherein the cooling system (10) is configured for cooling a plurality of electronic components (14, 16, 28, 30, 32), wherein the heat sink (12) comprises a plurality of pedestals (34, 36, 38), each forming an external surface (20) for mounting a respective electronic component (14, 16, 28, 30, 32) of the plurality of the electronic components (14, 16, 28, 30, 32).

13. An electronic control unit comprising a cooling system (10) according to any one of the precedent claims.

14. A vehicle with an electronic control unit according to claim 13, wherein the electronic control unit is connected to a cooling circuit of the vehicle for guiding a liquid from the cooling circuit through the at least one cooling channel (22, 40, 42, 44, 46) of the heat sink (12) of the cooling system (10) of the electronic control unit.

15. A method for assembling a cooling system (10) for cooling an electronic component (14, 16, 28, 30, 32), the method comprising:
- forming at least one opening (24) through an external surface (20) of a heat sink (12), wherein the at least one opening (24) exposes at least partially a cooling channel (22, 40, 42, 44, 46) of the heat sink (12) (step S1);
- dispensing a sealing material (26) in a liquid state over the external surface (20) around the at least one opening (24) for forming a molding (step S2); and
- pressing the electronic component (14, 16, 28, 30, 32) onto the molding formed by the sealing material (26) (step S3).
